(19) Europäisches Patentamt
European Patent Office
Office européen des brevets

(11) **EP 4 386 403 B1**

(12) **FASCICULE DE BREVET EUROPEEN**

(45) Date de publication et mention
de la délivrance du brevet:
**29.10.2025 Bulletin 2025/44**

(21) Numéro de dépôt: **23208105.9**

(22) Date de dépôt: **07.11.2023**

(51) Classification Internationale des Brevets (IPC):
**G01R 31/367** (2019.01)     **G01R 31/382** (2019.01)
**G01R 31/392** (2019.01)     **G01R 31/396** (2019.01)
**G01R 31/3842** (2019.01)

(52) Classification Coopérative des Brevets (CPC):
**G01R 31/392; G01R 31/367; G01R 31/382;
G01R 31/3842; G01R 31/396**

(54) **PROCEDE ET DISPOSITIF DE DETERMINATION D'UN PROFIL DE SOLLICITATION REPRESENTATIF DE L'USAGE FUTUR D'UNE BATTERIE POUR UNE APPLICATION DONNEE**

VERFAHREN UND VORRICHTUNG ZUR BESTIMMUNG EINES DIE ZUKÜNFTIGEN NUTZUNG EINER BATTERIE REPRÄSENTATIVEN BELASTUNGSPROFILS FÜR EINE BESTIMMTE ANWENDUNG

METHOD AND DEVICE FOR DETERMINING A STRESS PROFILE REPRESENTING THE FUTURE USE OF A BATTERY FOR A GIVEN APPLICATION

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **14.12.2022 FR 2213313**

(43) Date de publication de la demande:
**19.06.2024 Bulletin 2024/25**

(73) Titulaire: **Commissariat à l'Energie Atomique et
aux Energies
Alternatives
75015 Paris (FR)**

(72) Inventeurs:
• **KAROUI HENCHIRI, Fathia
38054 Grenoble Cedex 09 (FR)**
• **VINIT, Laurent
38054 Grenoble Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
EP-A1- 3 936 878     CN-A- 106 980 725
FR-A1- 3 118 310     US-A1- 2022 373 609

• VILSEN SOREN B. ET AL: "Transfer Learning for Adapting Battery State-of-Health Estimation From Laboratory to Field Operation", IEEE ACCESS, 3 March 2022 (2022-03-03), Piscataway, pages 26514 - 26528, XP093071023, Retrieved from the Internet <URL:https://ieeexplore.ieee.org/ielx7/6287639/9668973/09727154.pdf?tp=&arnumber=9727154&isnumber=9668973&ref=aHR0cHM6Ly93d3cuZ29vZ2xlLmNvbS8=> [retrieved on 20230806], DOI: 10.1109/ACCESS.2022.3156657
• BHATT ANKIT ET AL: "Machine learning-based approach for useful capacity prediction of second-life batteries employing appropriate input selection", vol. 45, no. 15, 12 August 2021 (2021-08-12), GB, pages 21023 - 21049, XP093071022, ISSN: 0363-907X, Retrieved from the Internet <URL:https://onlinelibrary.wiley.com/doi/full-xml/10.1002/er.7160> [retrieved on 20240322], DOI: 10.1002/er.7160

**Description**

**Domaine de l'invention**

L'invention concerne le domaine technique des batteries, et porte sur un procédé et un dispositif permettant de déterminer un profil représentatif de l'usage futur d'une batterie pour une application donnée, dit profil de sollicitation, et plus particulièrement un profil de l'usage de batteries Lithium-ion.

**Etat de la technique**

Les batteries lithium dans leurs différentes variantes telles que par exemple les batteries « lithium-ion » ou « lithium-ion-polymère » ou « lithium-métal-polymère », sont les batteries présentant une des plus grandes densités d'énergies et une des plus grandes énergies spécifiques. Il s'agit de la technologie de choix pour l'alimentation de nombreuses applications telles que par exemple les véhicules électriques ou hybrides, les dispositifs portables.

Cependant, ces batteries présentent une dégradation de leurs performances au cours du temps, notamment une dégradation de capacité et de résistance électrique, cela même pendant les périodes de non utilisation, et l'on parle de « vieillissement ou dégradation calendaire ».

La dégradation en cyclage se produit lorsque la batterie est soumise à une sollicitation électrique, lors d'une charge ou d'une décharge, alors que la dégradation calendaire survient constamment au cours de la vie de la batterie, qu'elle soit soumise à une sollicitation électrique ou non.

La prise en compte de l'évolution prévisionnelle des performances d'une batterie présente de nombreux avantages à différents niveaux d'un système qui l'incorpore, que ce soit pour son dimensionnement, sa maintenance, pour les stratégies de pilotage, entre autres.

Les performances des batteries peuvent être mesurées grâce à la mise en place d'indicateurs tels que l'état de santé ou SOH (acronyme de « State Of Health » selon l'anglicisme consacré), indicateurs qui sont calculés via des signaux physiques mesurés directement sur la batterie.

L'évolution prévisionnelle de ces indicateurs, et donc des performances des batteries pour un profil de sollicitation d'une batterie et pour une application donnée, peut être simulée au moyen d'un modèle de vieillissement ou modèle d'endurance, qui est préalablement paramétré.

Pour un type de modèle de vieillissement donné, généralement basé sur un modèle de vieillissement empirique simple d'utilisation, des cartographies des paramètres du modèle sont établies au moyen d'une base de données qui est constituée de résultats d'essais d'endurances de la batterie étudiée. Le contenu de cette base de données peut être plus ou moins riche en fonction du nombre d'essais d'endurance réalisés. L'étendue de la campagne d'essais d'endurance est déterminée en fonction d'un nombre de paramètres d'étude qui peuvent influencer les performances de la batterie.

Généralement, les conditions d'endurance choisies pour la réalisation des essais expérimentaux sont des conditions non variables - stabilité en température, stabilité en état de charge de la batterie ou SOC (acronyme de « State of Charge » selon l'anglicisme consacré), stabilité en courant électrique (i.e. le niveau de sollicitation électrique) - afin de pouvoir identifier les effets de ces paramètres sur la dégradation de la batterie. Le modèle de vieillissement utilisé permet ensuite de lier ces différents effets les uns aux autres, et il est alors possible d'estimer les dégradations pour des profils d'utilisation plus complexes, pour lesquels ces conditions peuvent être variables.

Les cartographies de paramètres pour un modèle étant déterminées pour des conditions non variables, il est alors souvent intéressant de disposer de résultats d'essais expérimentaux réalisés pour des conditions d'endurance variables représentatives de conditions d'usage futur des batteries pour une application particulière, et ce à des fins de validation du modèle.

Les essais des batteries avec ces profils de sollicitation sont réalisés sur des bancs d'essais électriques pour lesquels il est possible de programmer différents profils de sollicitations, cependant avec un nombre de points limité. Or, un profil de sollicitation, même avec un nombre de points limité, doit rester représentatif de l'usage réel de la batterie, ce qui n'est en général pas le cas.

Il existe différentes approches dans l'art antérieur pour établir des profils de sollicitation de batterie.

Le document de S. B. Vilsen and D.-I. Stroe, "Transfer Learning for Adapting Battery State-of-Health Estimation From Laboratory to Field Operation," IEEE Access, vol. 10, pp. 26514-26528, 2022, doi: 10.1109/ACCESS.2022.3156657, présente une méthode pour extraire un profil de fonctionnement d'un chariot élévateur, en prenant en entrée des données d'opération d'une période de 6 mois de trois chariots élévateurs, et où les périodes de repos ont été supprimées. Le profil résultant extrait de 12-15 jours est un profil de test accéléré utilisé pour le cyclage des batteries en laboratoire, où les conditions des mesures ne reproduisent pas fidèlement le fonctionnement réel. Par exemple, le banc du cyclage ne permettait pas d'aller au-delà de 50 Ampères alors que pendant le fonctionnement réel, il y avait des pics de 350 Ampères. Pour compenser ces limitations, la décharge a été prolongée jusqu'à ce que le profil de vieillissement en laboratoire à 50 Ampères, arrive au même état de charge que le profil de fonctionnement des trois chariots élévateurs.

Aussi, dans cette approche, le profil n'est pas représentatif de l'usage réel. De surcroit les batteries Lithium-ion vieillissant aussi pendant les périodes de repos, ces périodes ne sont pas considérées.

Dans la demande de brevet CN106980725B, le procédé proposé permet d'extraire les phases de fonctionnement de la batterie d'un véhicule (dans un parking, en roulage et en démarrage), d'un profil normé NEDC (acronyme de « New European Driving Cycle » en anglais), pour réaliser ensuite des simulations de fonctionnement et permettre de dimensionner la batterie. Or ce profil n'est utilisable que pour des applications automobiles, i.e. des batteries embarquées, et uniquement pour la mesure de la consommation et des émissions polluantes des véhicules.

D'autres approches comme celle décrite dans l'article d'A. Bhatt, W. Ongsakul, N. Madhu Manjiparambil, and J. G. Singh, "Machine learning-based approach for useful capacity prediction of second-life batteries employing appropriate input selection," International Journal of Energy Research, vol. 45, no. 15, pp. 21023-21049, 2021, doi: 10.1 002/er. 7160, utilisent la base de données publique « NASA Prognostics Data Repositry » pour obtenir des profils de simulations, utilisés pour l'apprentissage d'algorithmes de prédiction de l'état de santé des batteries. Les profils de la base de données sont des profils de test en laboratoire, et ils ne sont donc pas soumis à des contraintes de systèmes en fonctionnement réel.

Les documents FR3118310A1, US2022/037609A1 et EP3936878A1 divulguent des procédés pour estimer la durée de vie, le vieillissement ainsi que l'état de santé d'une batterie.

Il en résulte que selon les approches connues, les profils de sollicitation électrique utilisés dans des simulations de vieillissement de systèmes, ne sont pas représentatifs d'un usage réel d'une batterie, et ce pour chaque système opérationnel. De ce fait, la projection de durée de vie d'une batterie qui en résulte, n'est pas assez fiable et précise.

Aussi, il existe le besoin d'une méthode qui permette d'établir des profils de sollicitation qui lève les inconvénients des approches connues.

La présente invention répond à ce besoin.

## Description brève de l'invention

La présente invention a pour objet un procédé de détermination de profils de sollicitation, représentatifs d'usages futurs d'une batterie pour des applications spécifiques.

Avantageusement, le procédé de l'invention permet de générer des profils de sollicitation qui sont compatibles avec des contraintes expérimentales liées aux essais d'endurance en laboratoire de batteries Li-ion.

Le procédé de l'invention permet de définir des profils de sollicitation représentatifs de l'usage d'une batterie ou représentatifs d'une séquence d'utilisation restreinte d'une batterie, à partir de données issues d'un suivi de batterie en opération réelle, sur une durée longue (annuelle ou plus longue).

Selon un aspect particulier, le procédé de l'invention permet de déterminer un profil de sollicitation électrique qui est représentatif de l'utilisation des batteries dans des systèmes de stockage par batterie.

De manière avantageuse, l'invention permet à partir de l'analyse de données opérationnelles de systèmes stationnaires, enregistrées sur une longue durée, de déterminer des profils représentatifs de l'usage de batteries dans des systèmes de stockage par batterie stationnaires.

Avantageusement, les profils établis sont des profils en nombre de points limités, qui sont représentatifs d'un usage réel futur de la batterie pour une application donnée.

Les profils de sollicitation établis peuvent entre autre être utilisés pour la validation de modèles de vieillissement dans des simulations. Ils peuvent aussi permettre de tester expérimentalement l'endurance d'un système (avec un profil de sollicitation adapté), et aussi permettre un dimensionnement optimal d'un système de batteries pour une application donnée.

Les profils de sollicitation peuvent de plus servir dans la modélisation des batteries en vue de réaliser un pronostic d'état de santé.

A cet effet, il est proposé un procédé de détermination de profils de sollicitation pour système de stockage par batterie. Le procédé est mis en œuvre par ordinateur et comprend au moins des étapes consistant à :

- calculer une durée d'opération d'un système de stockage par batterie, à partir d'un historique de données collectées sur une période de surveillance dudit système, les données comprenant au moins des valeurs de courant I(t), de température T(t), de tension U(t) et des valeurs d'état de charge SOC ;

- effectuer pour la durée d'opération, des analyses de statistiques d'usage de la batterie quant à l'état de charge SOC et la profondeur de décharge DOD ;

- découper ladite durée d'opération en n séquences temporelles, la durée d'une séquence étant représentative du fonctionnement dudit système de stockage pour une application donnée ;

- effectuer pour chacune des n séquences temporelles, des analyses de statistiques d'usage de la batterie quant à l'état de charge SOC et la profondeur de décharge DOD ;

- déterminer parmi les n séquences temporelles, une pluralité m de séquences qui ont des états de charge et des profondeurs de décharge comparables à des états de charge et des profondeurs de décharge pour la durée d'opération ;

- déterminer parmi les m séquences comparables, des séquences symétriques correspondant à des séquences ayant un état de charge en fin de période égal à l' état de charge en début de période ; et

- sélectionner parmi les séquences symétriques, une séquence représentative d'un profil de sollicitation pour ledit système de stockage.

Avantageusement, le procédé de l'invention comprend des variantes de réalisation différenciées ou combinées.

Ainsi, le procédé peut comprendre une étape initiale de filtrage des données, consistant à déterminer sur la période de collecte des données, une sous-période de surveillance, correspondant soit à une période avec le moins de trous de données, soit à une période où il y a le moins de données non numériques.

De préférence, la durée d'opération correspond à une moyenne des heures d'opération sur la période de surveillance dudit système de stockage.

L'étape d'analyses de statistiques pour la durée d'opération est de préférence faite sur des histogrammes du temps passé par intervalle d'état de charge et sur des histogrammes du temps passé par intervalle de profondeur de décharge.

Dans un mode de réalisation, l'étape d'analyses de statistiques pour chacune des n séquences temporelles est faite sur des histogrammes, pour chacune des n séquences, du temps passé par intervalle d'état de charge et sur des histogrammes, pour chacune des n séquences, du temps passé par intervalle de profondeur de décharge.

Le procédé peut comprendre une étape initiale consistant à vérifier la fiabilité des valeurs d'état de charge, et si besoin une étape consistant à calculer un état de charge fiable.

Le procédé peut comprendre une étape consistant à calculer des valeurs de profondeur de décharge.

Dans un mode de réalisation, l'étape de sélectionner une séquence représentative d'un profil de sollicitation pour ledit système de stockage, consiste à :

- récupérer des profils de courant ou des profils de puissance correspondant aux séquences symétriques ; - calculer une différence point par point entre chaque profil de courant ou de puissance récupéré et un profil moyen ; et - sélectionner un profil correspondant à celui ayant une différence minimale avec le profil moyen.

Le procédé peut comprendre une étape consistant en une mise à l'échelle du profil de sollicitation sélectionné comme profil représentatif.

Un autre objet de l'invention concerne un dispositif de détermination de profils de sollicitation pour système de stockage par batterie, qui comprend des moyens pour mettre en œuvre les étapes du procédé de l'invention.

Dans une réalisation, le dispositif de l'invention est appliqué pour un système de stockage stationnaire, de préférence un système de stockage par batteries « BESS ».

De préférence, le système de stockage comporte au moins une batterie au lithium-ion.

Un autre objet de l'invention est un dispositif pour simuler le vieillissement des batteries d'un système de stockage par batterie, le dispositif comprenant au moins un processeur pour exécuter un modèle de vieillissement de batterie ainsi qu'un deuxième dispositif de détermination de profils de sollicitation pour système de stockage par batterie selon l'invention, ledit modèle étant appliqué sur la base d'un profil de sollicitation déterminé par ledit deuxième dispositif, ledit profil étant donc obtenu par le procédé de l'invention.

L'invention adresse aussi un programme d'ordinateur comprenant des instructions de code qui, lorsque le programme est exécuté par un ordinateur, conduisent celui-ci à mettre en œuvre le procédé de détermination de profils de sollicitation pour système de stockage par batterie de l'invention.

## Brève description des figures

D'autres caractéristiques, détails et avantages de l'invention ressortiront à la lecture de la description faite en référence aux dessins annexés donnés à titre d'exemple et qui représentent :

La figure 1 est un diagramme de flux des étapes du procédé de détermination de profils de sollicitation électrique, selon un mode de réalisation de l'invention ;

Les figures 2a et 2b illustrent des exemples d'histogrammes des temps passés respectivement, par plage d'état de charge (SOC) et par plage de profondeur de décharge (DOD) d'une batterie sur une période de 4 ans d'enregistrement de données ;

Les figures 3a et 3b illustrent des exemples d'histogrammes des temps passés respectivement, par plage d'état de charge (SOC) et par plage de profondeur de décharge (DOD) d'une batterie sur une période de 7 jours pour des séquences représentatives ;

La figure 4 est un diagramme de flux des étapes du procédé de détermination de profils de sollicitation électrique, selon des modes de réalisation de l'invention incluant des étapes optionnelles.

**Description détaillée de l'invention**

Il est d'abord fait un rappel de différents principes et définitions connus dans le domaine des batteries, et repris dans la suite de la description.

L'état de charge (SOC) d'une batterie représente la quantité de charge électrique stockée q(t) par rapport à la capacité actuelle C(t), et est exprimé par l'équation (1) :

$$SOC(t) = \frac{charge\ électrique\ stockée}{capacité\ actuelle} = \frac{q(t)}{C(t)}$$

L'état de charge d'une batterie est exprimé en pourcentage et varie usuellement entre 0% désignant une batterie totalement déchargée (état vide) et 100% désignant une batterie totalement chargée (état plein). Le niveau d'état de charge avec le plus de temps passé influence le vieillissement calendaire et le vieillissement en cyclage.

La profondeur de décharge (DOD) (acronyme de « Depth Of Discharge » en anglais) d'un cycle, correspond au pourcentage de la quantité de charge enlevé de la batterie en partant d'un état de charge donné. La profondeur de décharge avec laquelle une batterie est cyclée influence son vieillissement en cyclage.

Système de stockage électrochimique par batterie : c'est un système qui contient une ou plusieurs batteries capables d'emmagasiner l'énergie électrique (sous une forme chimique) et de la restituer en temps voulu. Il existe deux types de systèmes de stockage électrochimique par batterie : les systèmes de stockage par batterie stationnaires et les systèmes de stockage par batterie embarqués.

Le stockage stationnaire permet notamment d'assurer l'équilibre entre la production et la consommation d'électricité, sur un réseau de distribution électrique, et en particulier permet de pallier la variabilité de la production des énergies renouvelables (énergies solaire, éolienne...). Par exemple, l'électricité produite en excès lors d'une journée très ensoleillée peut être restituée en soirée lorsque la demande est plus importante. Le stockage stationnaire contribue également à garantir la qualité du réseau de distribution électrique en limitant les fluctuations causées par l'intermittence de la production des énergies renouvelables. Enfin, le stockage stationnaire permet de répondre aux besoins des sites isolés, difficilement alimentés ou non alimentés par les réseaux de distribution.

Les systèmes de stockage par batterie stationnaires sont principalement des systèmes de stockage à grande échelle, de moyenne ou forte puissance (de l'ordre de plusieurs centaines de kilowatt (kW) à plusieurs dizaines de Mégawatt (MW=), ayant des énergies élevées (de l'ordre de plusieurs centaines de kilowatt-heure (kWh) à plusieurs dizaines de Mégawatt-heure (MWh)).

A l'inverse, les systèmes de stockage embarqués sont sur de plus petite quantité d'énergie (de quelques Watt-heure (Wh) à quelques dizaines de kWh) et sont de puissance moindre (de quelques watts (W) à quelques centaines de kW). Ces systèmes sont dédiés aux applications mobiles. Ils sont essentiellement utilisés dans le transport, en particulier dans les véhicules électriques et hybrides rechargeables, et dans les appareils électroniques nomades (téléphones, tablettes, ordinateurs...).

La présente description est faite pour un mode de réalisation du procédé de l'invention appliqué au cas de systèmes de stockage stationnaires, désignés par l'acronyme BESS (pour « Battery Energy Storage System » selon l'anglicisme consacré), ayant des batteries Li-ion.

Cependant, l'homme du métier pourra appliquer les principes décrits à d'autres types de systèmes et pour d'autres applications.

Un BESS est un système de stockage stationnaire à grande échelle, couplé généralement à une unité de production d'énergie renouvelable (énergie solaire, éolienne...). Le système comprend plusieurs sections de batteries, chaque section de batteries comprenant des assemblages de batteries appelés « racks », chaque rack comprenant une pluralité de modules connectés entre eux, eux-mêmes constitués de cellules électrochimiques assemblées en série et en parallèle.

Lors de son utilisation, le système de stockage (qu'il soit stationnaire ou embarqué) est soumis à des contraintes de son environnement dites « contraintes de terrain » et est soumis à des conditions d'usage.

Les contraintes de l'environnement terrain sont par exemple, la présence d'éléments de connexion et d'éléments de protection, entre les cellules électrochimiques, entre les différentes batteries d'un rack, entre les différents racks d'une section de batteries (dans le cas d'un BESS). Elles peuvent aussi résulter de la présence d'un boîtier autour des cellules électrochimiques de chaque batterie, de la présence de systèmes électroniques de gestion, comme un système de gestion de batterie BMS (« Battery Management System » en anglais) et/ou un système de gestion d'énergie EMS (« Energy Management System »). Ces contraintes liées à l'usage réel du système de stockage ont une incidence sur les performances du système, notamment en termes de résistance interne (et donc d'échauffement et puissance), de capacité et de durée de vie.

Les conditions d'usage elles, sont définies par différents paramètres tels que les régimes de charge et de décharge auxquels les cellules électrochimiques sont soumises, les phases de cyclage et de repos des cellules électrochimiques et la température environnante. Ces conditions d'usage peuvent être différentes entre les batteries qui composent le système de stockage, voire entre les cellules électrochimiques d'une même batterie (pour ce qui est de la température).

On entend par « phases de cyclage » les phases pendant lesquelles les cellules électrochimiques du système de stockage subissent des cycles de charge et de décharge, c'est-à-dire les phases pendant lesquelles le système de stockage est utilisé. Dans ce cas, le système de stockage est dit « en mode cyclé »

On entend par « phases de repos » les phases pendant lesquelles les cellules électrochimiques du système de stockage ne sont pas sollicitées. Dans ce cas, le système de stockage est dit « en mode calendaire ».

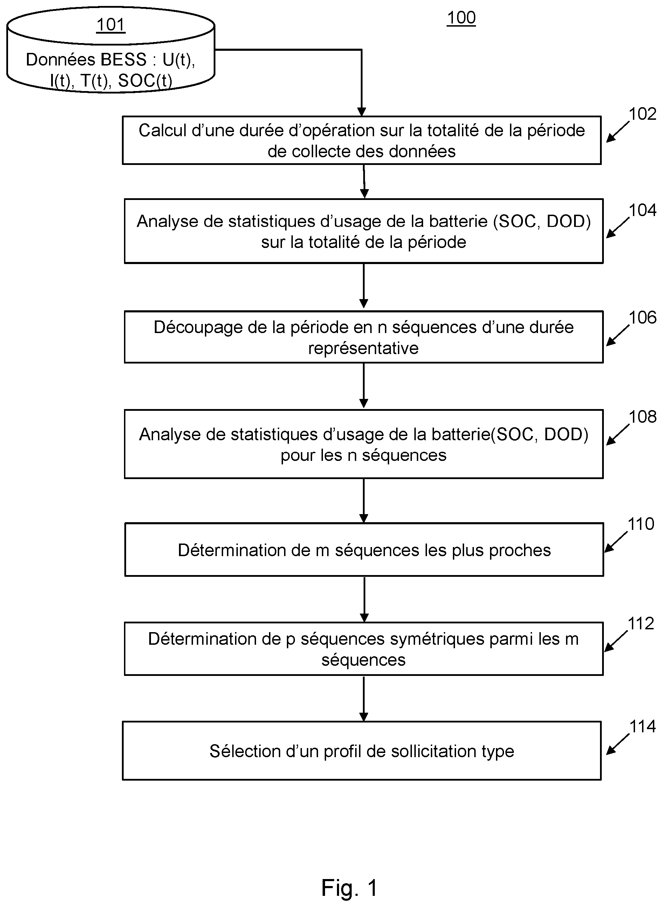

La figure 1 est un diagramme de flux des étapes du procédé 100 de détermination de profils de sollicitation électrique selon un mode de réalisation de l'invention appliqué à un système BESS.

Dans une première étape 102, après avoir récupéré un historique de données fiables de surveillance (« monitoring » en anglais) du fonctionnement d'un système BESS, le procédé permet de calculer un nombre moyen d'heures d'opération du système.

Il est à noter que la pertinence des résultats, et donc du profil de sollicitation issu du procédé 100, est liée à la qualité des données mises à disposition et utilisées comme entrées d'un dispositif permettant de mettre en œuvre les étapes du procédé de l'invention.

Un tel dispositif (non illustré) comprend des moyens appropriés pour recevoir des données d'entrées ; pour les traiter selon les différentes étapes du procédé de l'invention dans toutes leurs variantes ; et pour restituer les résultats obtenus dans une forme disponible pour leur exploitation (pour paramétrage d'un modèle de vieillissement par exemple).

Ainsi, un tel dispositif comprend au moins un module de réception de données configuré pour recevoir des données et le cas échéant les adapter (les filtrer pour retenir des données fiables) pour leur traitement par un module de traitement de données. Le module de traitement de données comprend un microprocesseur pour opérer des instructions de code d'un programme logiciel permettant d'effectuer les différentes étapes du procédé de l'invention. Les résultats obtenus par le module de traitement de données peuvent être adaptés à une interface homme-machine pour leur exploitation (dans des simulations de test de batteries par exemple).

Les données d'entrées qui sont un prérequis à la mise en œuvre des étapes du procédé, sont notamment un historique de données opérationnelles collectées sur un système de stockage, et correspondant à des données de tension $U(t)$, de courant $I(t)$, de température $T(t)$, d'état de charge $SOC(t)$.

La collecte de données correspond à des enregistrements faits de ces données pour un système de stockage d'énergie par batteries (par exemple stationnaire BESS), sur une très longue durée, d'au moins plusieurs mois à plusieurs années.

Les données initiales d'entrées peuvent avoir été collectées par un ou plusieurs systèmes de gestion BMS associé au BESS, et avoir été stockées dans une base de données dédiée 101 ou être filtrées parmi d'autres données enregistrées dans une base de données plus générale d'un système de gestion BMS.

Dans le cas où les données initiales ne présentent pas de trous et que l'ensemble des modules de la batterie du système BESS est connecté en permanence (i.e. pas de rack non-opérant sur certaines plages de temps), les données sont considérées comme fiables et le calcul 102 du nombre d'heures d'opération du système (ou le calcul d'un pourcentage d'heures) est fait directement sur les données initiales reçues.

Dans le cas contraire (les données présentent des trous), une étape de nettoyage ou de filtrage des données reçues est effectuée pour améliorer la qualité des données, et les données filtrées, correspondant à une nouvelle période, sont utilisées pour calculer le nombre d'heures d'opération.

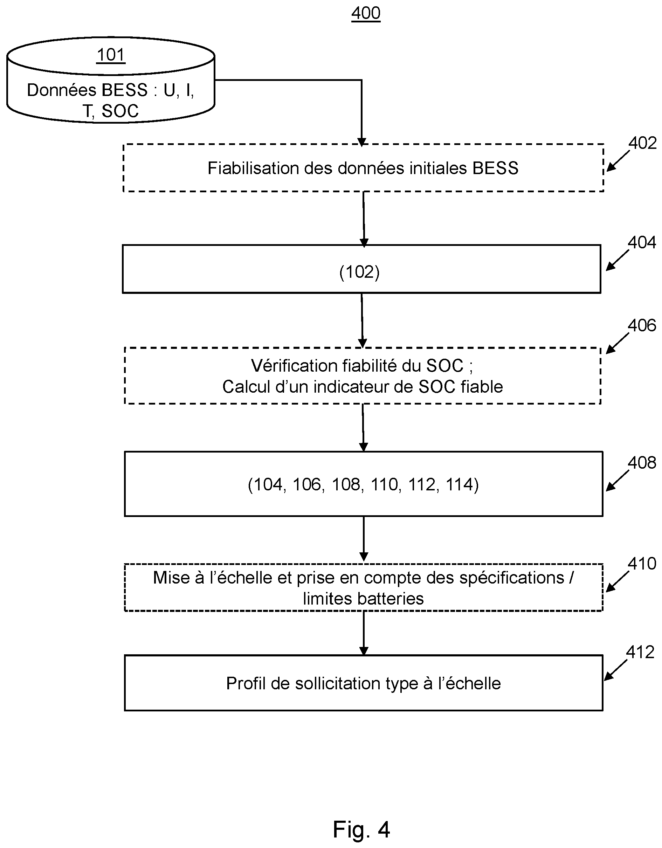

La figure 4 illustre des étapes optionnelles (402, 406, 410) du procédé 100 de l'invention, pouvant être réalisées indépendamment les unes des autres, dont une étape 402 de préparation de données fiables. Ainsi, le procédé de l'invention peut être réalisé selon différentes variantes combinant des étapes requises (figure 1) et une ou plusieurs étapes optionnelles (illustrées en pointillées sur la figure 4).

Dans un mode de réalisation, l'étape optionnelle 402 de nettoyage des données initiales consiste à choisir, sur la période de l'historique des données reçues, une nouvelle période de longue durée pour la disponibilité de données. Cette nouvelle période longue peut répondre à un critère dit « période avec le moins de trous de données » pouvant signifier soit une période ayant le moins de sous-périodes avec absence de données, soit une période où il y a le moins de données non numériques dites (NaN) acronyme de « Not a Number » selon l'anglicisme consacré pour désigner des données non valides ou des données non disponibles.

En effet, la disponibilité est un critère qui qualifie trois indicateurs.

Un premier indicateur porte sur la remontée correcte de données (le fait que les données soient valides, i.e. soient des données numériques), et sur le fait que les valeurs des données soient dans les limites de fonctionnement (i.e. ni trop grandes, ni trop faibles). Cet indicateur est caractérisé par une sortie journalière d'un paramètre ici désigné par « Data_hours ». Des données hors limites ne sont pas prises en compte dans l'estimation du paramètre Data_hours.

Un deuxième indicateur est relatif au nombre d'heures par jour du fonctionnement opérationnel du système (hors plages de repos « Idle »). Cet indicateur est caractérisé par un paramètre ici désigné par « Operation_hours ». La valeur du paramètre Operation_hours est en principe inférieure ou égale à la valeur du paramètre Data_hours.

Un troisième indicateur est relatif à la proportion de racks connectés pour une journée donnée, désigné ici par le paramètre « AvailableRacks ».

Revenant à l'étape 102, les périodes de fonctionnement qui sont prises en compte pour permettre de déterminer un profil de sollicitation représentatif, doivent avoir un paramètre 'heures d'opération' « Operation_hours » correspondant à une moyenne des heures d'opération de la totalité de la période de monitoring du système de stockage.

En cas d'étape optionnelle de préparation 402, les périodes de fonctionnement qui sont prises en compte pour déterminer un profil de sollicitation représentatif, doivent de plus avoir un paramètre « Data_hours » maximisé et un paramètre « AvailableRacks » maximisé.

Après l'étape de calcul des heures d'opération (le nombre d'heures d'opération en total hors inactivité), soit en 102 sur des données directement fiables, soit en 404 après une étape 402 de préparation de données fiables, le procédé permet dans une étape suivante 104, de faire une analyse des statistiques d'usage de la batterie sur la totalité de la période de données.

Le procédé de l'invention peut effectuer, avant l'étape 104, une étape optionnelle 406 qui consiste à vérifier si l'indicateur d'état de charge SOC qui a été reçu et qui avait été calculé par le système de gestion de la batterie (BMS) est fiable.

La fiabilité de la valeur de SOC est estimée selon une relation entre les valeurs de capacité (Ampères-Heures Ah) des accumulateurs chargés et déchargés, et la différence d'état de charge entre le début et la fin de chaque période de charge ou de décharge. Si cette relation est linéaire, l'état de charge fourni par le BMS est considéré comme fiable. Sinon, l'état de charge fourni par le BMS n'est pas considéré comme fiable, et le procédé permet de construire un état de charge fiable, i.e. déterminer un nouvel indicateur permettant de définir un état de charge fiable.

Dans un mode de réalisation, un état de charge SOC fiable peut être obtenu par application d'une méthode d'intégration des Ah complétée par une méthode de recalage. Il s'agit d'une méthode classique de calcul de l'état de charge d'une batterie. On part d'un état de charge donné (même par le BMS y compris s'il est considéré comme non fiable). Ensuite on intègre le courant de la batterie pour obtenir des Ah, les Ah sont ensuite divisés par la capacité de la batterie pour obtenir un état de charge. Ensuite, si le système détecte un moment propice à une estimation fiable de l'état de charge (par exemple, l'atteinte d'une condition de pleine charge, ou de décharge complète, ou un repos suffisamment long, etc...), le calcul recale l'état de charge à une valeur déterminée par ces conditions de recalage. Un exemple peut être trouvé à l'adresse http://liionbms.com/php/wp_soc_estimate.php, "State Of Charge estimate with Li-Ion batteries" by Davide Andrea.

Revenant à la figure 1, et l'étape 104, le procédé permet de faire une analyse des statistiques d'usage de la batterie, par rapport à une durée cumulée.

La durée cumulée désigne le temps passé par intervalle d'état de charge (ou de profondeur de décharge). L'état de charge de la batterie est divisé en une pluralité d'intervalles, et le temps passé dans chaque intervalle est cumulé. La durée cumulée de chaque intervalle est ensuite divisée par la durée totale de la période, pour obtenir une valeur de temps passé.

Ainsi à l'étape 104, le procédé permet de construire des histogrammes sur la totalité de la période de collecte, l'un pour les états de charge SOC et un autre pour les profondeurs de décharge DOD. Les histogrammes sont construits à partir de l'historique des données collectées, sur la totalité de la période de surveillance (avec des données initiales fiables), soit sur une sous-période (avec des données filtrées, rendues fiables).

Un premier histogramme d'usage est construit pour les temps cumulés passés par intervalle pour l'état de charge de la batterie, correspondant à des statistiques globales sur la totalité de la période retenue (période initiale ou période recalculée).

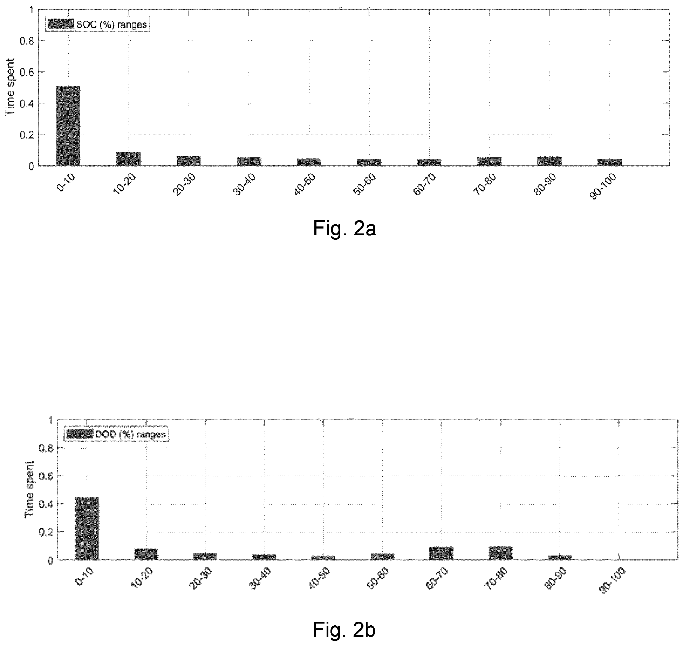

La figure 2a montre un exemple d'un histogramme d'usage pour des temps cumulés passés (« Time Spent » en ordonnée) par intervalle d'état de charge (SOC) d'une batterie pour 10 intervalles, sur une période de 4 ans. Il peut être noté pour cet exemple, que la batterie passe la plupart du temps à faible état de charge.

L'état de charge pour construire l'histogramme peut être celui fourni directement par le BMS ou être un état de charge reconstruit (étape 406).

Un deuxième histogramme d'usage est construit pour les temps cumulés passés par intervalle pour la profondeur de décharge de la batterie, correspondant à des statistiques globales sur la totalité de la période retenue (période initiale ou période recalculée).

La figure 2b montre un exemple d'un histogramme d'usage pour des temps cumulés passés (« Time Spent » en ordonnée) par intervalle de profondeur de décharge (DOD) d'une batterie pour 10 intervalles, sur une période de 4 ans. Il peut être noté pour cet exemple, que la batterie passe beaucoup de temps dans un état inactif (profondeur de décharge inférieur à 10%), et quand elle est déchargée, la plupart des cycles ont une profondeur de décharge entre 70 et 80% puis entre 60 et 70%.

La profondeur de décharge est calculée par algorithme, car elle n'est pas donnée directement par le BMS. Dans un mode de réalisation, l'algorithme se base sur une méthode de comptage connue, comme par exemple la méthode de comptage « Rainflow ».

La méthode de comptage Rainflow, développée à l'origine dans le domaine des matériaux pour des estimations de fatigue cyclique, est aujourd'hui utilisée dans de nombreuses applications où un comportement cyclique peut être observé, notamment dans l'éolien, les machines tournantes, et la charge des batteries. La méthode de comptage Rainflow consiste à associer par paire les minima croissants et les maxima décroissants d'une courbe initiale, et elle peut être mise en œuvre par de nombreux algorithmes connus.

Pour chaque cycle sélectionné, une quantité d'Ah déchargée est estimée par intégration du courant. Puis la quantité d'Ah estimée est divisée par la capacité nominale pour calculer la profondeur de décharge du cycle concerné.

Revenant à la figure 1, le procédé permet, dans une étape suivante 106, de définir une durée de séquence qui soit représentative de l'usage du BESS dans l'application donnée.

Une durée de séquences qui est représentative de l'usage du BESS est souvent égale à une journée (24 h), mais d'autres durées peuvent être considérées selon l'application pour lequel il est utilisé.

Le choix de la durée de séquences peut être progressif. Le procédé peut commencer par vérifier si une période courte (par exemple une journée pour une application de stockage stationnaire utilisé avec un système solaire), supposée pouvoir être représentative de l'usage de la batterie, est valide, et augmenter la durée jusqu'à atteindre une représentativité correcte.

Selon des variantes de réalisation, si une durée de séquence d'une journée n'est pas représentative, les durées de séquences peuvent être testées par durées d'une semaine.

Pour déterminer si une durée est représentative, le procédé permet d'établir des histogrammes du SOC et du DOD pour toutes les durées sur la période de collecte des données. Par exemple pour une durée testée de 24h pour une collecte de données faite sur une année, un histogramme de SOC (et de DOD) est établi pour toutes les journées sur une année.

S'il est identifié dans les histogrammes, des séquences de la durée testée (pour l'exemple 24 heures) qui présentent des histogrammes similaires à ceux de la totalité de la période de collecte des données, cette durée de séquences est conservée.

S'il n'est pas identifié de telles séquences « similaires », la durée de la séquence peut être augmentée progressivement par exemple par durée de 24 h en passant à 2 jours, puis à 3 jours, etc., jusqu'à trouver des séquences avec des histogrammes similaires à ceux de la totalité de la période.

Quand une durée de séquences représentative est déterminée, le procédé permet de découper la période totale de collecte des données en une pluralité n de séquences de durée égale à la durée représentative.

Le procédé poursuit ensuite par une étape 108 consistant à faire une analyse des statistiques d'usage de la batterie, notamment l'analyse du SOC et du DOD, pour chacune des séquences de la pluralité des n séquences temporelles définies.

Le procédé permet initialement de construire deux nouveaux types d'histogrammes pour faire les analyses de statistiques d'usage.

Un premier type d'histogramme est construit pour les temps cumulés passés par intervalle pour l'état de charge de la batterie, sur la durée représentative définie.

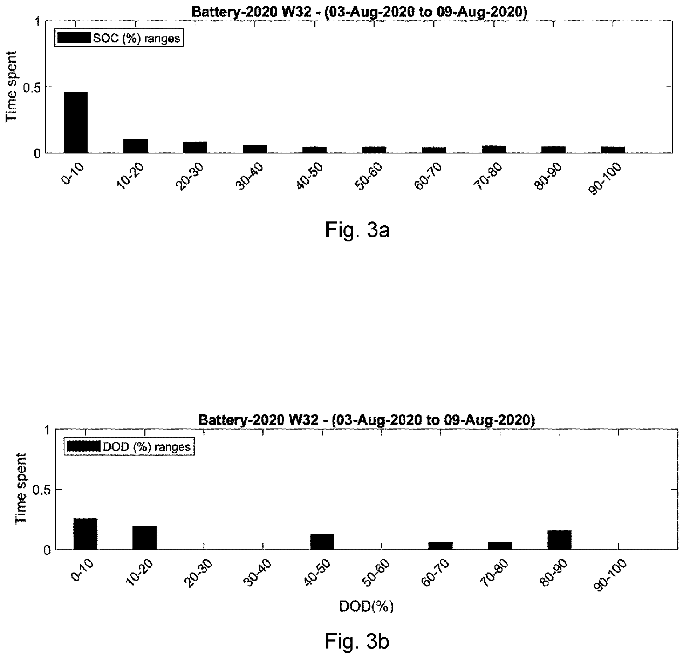

La figure 3a montre un exemple d'un histogramme des temps cumulés passés par intervalle pour l'état de charge (SOC) d'une batterie, sur une durée d'une semaine, pour une séquence parmi les n séquences identifiées.

Un deuxième type d'histogramme est construit pour les temps cumulés passés par intervalle pour la profondeur de décharge de la batterie, sur la durée représentative définie.

La figure 3b montre un exemple d'un histogramme des temps cumulés passés par intervalle pour la profondeur de décharge (DOD) d'une batterie, sur une durée d'une semaine pour une séquence parmi les n séquences identifiées.

Il est ainsi construit n histogrammes pour l'état de charge, et n histogrammes pour la profondeur de décharge.

L'analyse des statistiques d'usage consiste ensuite à l'étape suivante 110, à comparer les n histogrammes des temps cumulés passés par intervalle pour l'état de charge et la profondeur de décharge, avec les histogrammes établis pour la totalité de la période de données (période initiale ou période recalculée) à l'étape 104.

Le résultat de la comparaison permet d'identifier parmi la pluralité des n séquences temporelles, un sous-ensemble de m séquences dites séquences les plus proches, i.e. des séquences qui sont dans des niveaux de temps passés qui sont similaires à ceux de la totalité de la période, et ce en termes d'intervalles d'état de charge et d'intervalles de profondeur de décharge.

Dans une étape suivante 112, le procédé permet d'identifier dans la pluralité des m séquences, des séquences représentatives qui sont symétriques, c'est-à-dire des séquences ayant un état de charge final qui soit égal à l'état de charge initial.

Il est important que l'état de charge ne dérive pas dans le temps (le profil revient à son point de départ d'un point de vue de son état de charge). En effet, le profil de sollicitation (représentatif de l'usage réel de la batterie pour une application donnée) va devoir être répété pour pouvoir tester ou simuler le vieillissement de la batterie (i.e. la séquence représentative va être répétée dans le temps pour estimer la dégradation selon cette séquence sur la durée).

Dans un mode de réalisation, l'identification des périodes (ou séquences) symétriques se fait en considérant l'état de charge au début de la période et à la fin de la période.

Dans une variante de réalisation, l'identification des périodes symétriques se fait en considérant un cycle symétrique sur une partie de la période représentative.

Dans une autre variante de réalisation, l'identification des périodes symétriques se fait en reconstituant des cycles symétriques.

Dans un mode de réalisation, la reconstitution de cycles symétriques peut se faire en convertissant l'ensemble des opérations de charge et de décharge de la période de mesure en un ensemble équivalent de cycles reconstitués symétriques, chaque cycle reconstitué symétrique comportant une opération de charge et une opération de décharge de même amplitude de l'indicateur d'état de charge (une même amplitude de charge ou de décharge).

Les cycles symétriques résultants de cette conversion sont dits « reconstitués » car ils sont issus d'une réorganisation, avec d'éventuelles approximations, de cycles réels.

Pour certaines applications, dont les cycles de charge/décharge sont simples et réguliers, un algorithme relativement simple se charge de cette conversion.

Pour des applications où les cycles de charge de décharge sont complexes et irréguliers, des algorithmes plus sophistiqués sont employés pour l'opération de conversion, comme par exemple la méthode de comptage rainflow.

Dans le cadre de la présente invention, la conversion en cycles reconstitués symétriques est réalisée en associant par paires les minima croissants et les maxima décroissants des opérations de charge et de décharge de la période de mesure.

Revenant à la figure 1, l'étape 112 permet donc la sélection d'une pluralité p de séquences correspondant à des périodes symétriques, parmi la pluralité des m séquences définies à l'étape précédente 110.

À l'issue de l'étape 112, le procédé a produit un ensemble équivalent de cycles reconstitués symétriques, relatifs à la période de mesure.

Ainsi, chaque séquence sélectionnée correspond à un profil d'état de charge qui est représentatif du fonctionnement de la batterie pour l'application donnée.

Cependant, étant donné que pour cycler une batterie, il faut appliquer des profils de courant ou de puissance, le procédé permet dans une étape suivante 114 de récupérer dans la base de données initiale, les profils de courant ou les profils de puissance correspondant aux p séquences sélectionnées.

Puis, le procédé permet de calculer la différence point par point entre chaque profil de courant (ou de puissance) récupéré et un profil moyen, puis permet de sélectionner un seul profil (profil final ou profil type) correspondant à celui ayant une différence minimale avec le profil moyen.

Le profil moyen est obtenu en faisant la moyenne, pour un pas de temps donné, entre les courants (ou les puissances) des p séquences sélectionnées obtenues précédemment. En effet à l'étape 114, il existe plusieurs profils de courant I=f(t) (ou plusieurs profils de puissance P= f(t)) et le profil moyen est calculé en prenant la moyenne de I (ou de P) pour chaque pas de temps.

La sélection à l'étape 114, du profil de sollicitation type, peut se faire en sélectionnant le profil ayant le moins de différences avec le profil moyen, en appliquant l'équation (2) suivante :

$$\min\left(\sum \mathrm{abs}\left(\mathrm{diff}(\mathrm{seq}(i), \mathrm{seqMoy})\right)\right).$$

Dans un mode de réalisation, le procédé peut comporter une étape optionnelle 410 après la sélection du profil type, qui consiste en une mise à l'échelle du profil type et son adaptation vis-à-vis des spécifications, des limites batteries, ou des moyens de test que l'on compte utiliser.

En effet, selon les données initiales de monitoring du BESS et le dimensionnement de celui-ci, il peut être nécessaire d'adapter le profil de sollicitation type issu de l'étape précédente 114 pour obtenir 412 un profil final à l'échelle, qui pourra être utilisé dans un modèle de vieillissement pour la batterie (ou un échantillon) que l'on souhaite tester. Cette adaptation est faite en fonction des contraintes et des limitations précisées dans la spécification batterie, et/ou en fonction des moyens d'essais.

Ainsi, par exemple pour certaines batteries, les courants maximums de charge peuvent être différents des courants maximums de décharge. Il conviendra alors de saturer le profil de courant avec des valeurs adéquates, en charge et en décharge selon ces limites.

L'équilibre du profil en état de charge pourra alors être maintenu grâce à l'application des équations (3) et (4) suivantes :

$$K_f = \frac{Ah_{ch} - Ah_{ch\_sat}}{Ah_{ch}} \ (3)$$

et

$$I_{dch} = I_{dch} \cdot K_f \ (4),$$

dans le cas d'un courant maximum de charge qui est inférieur au courant maximum de décharge (cas classiquement rencontré).

Les paramètres des équations (3) et (4) sont définis comme étant :

- $Ah_{ch}$ : il s'agit du cumul des Ah chargés (les phases du profil pour lesquelles le courant est positif) ;

- $Ah_{ch\_sat}$ : il s'agit du cumul des Ah chargés lorsque le courant est saturé à une valeur inférieure au courant de charge du profil initial.

En appliquant le coefficient $K_f$ au profil de courant de décharge $I_{dch}$, on réduit son niveau proportionnellement au profil de courant de charge saturé. Le résultat obtenu est ainsi un profil « équilibré », c'est-à-dire qu'on charge autant qu'on décharge, tout en conservant la dynamique.

Ce profil peut être répété cycliquement sur un échantillon sans avoir à définir un profil de la durée du test électrique souhaité. En effet, généralement les bancs d'essais ne permettent pas de définir des profils très longs ou de définir des profils sur un nombre de points très élevé.

Dans une variante de réalisation, le coefficient de correction Kf peut être appliqué uniquement sur les cycles nécessaires, c'est-à-dire s'il y a saturation en charge, le coefficient est appliqué sur la décharge suivante du même cycle (et inversement si saturation en décharge). La détection des cycles peut être faite via la méthode de comptage Rainflow.

Dans une autre variante de réalisation, la correction du profil de SOC est faite en appliquant un SOC initial différent.

## Revendications

1. Procédé de détermination de profils de sollicitation pour système de stockage par batterie, le procédé étant mis en œuvre par ordinateur et comprenant au moins des étapes consistant à :

   - calculer (102) une durée d'opération d'un système de stockage par batterie, à partir d'un historique de données collectées sur une période de surveillance dudit système, les données comprenant au moins des valeurs de courant I(t), de température T(t), de tension U(t) et des valeurs d'état de charge SOC ;
   - effectuer (104) pour la durée d'opération, des analyses de statistiques d'usage de la batterie quant à l'état de charge SOC et la profondeur de décharge DOD ;
   - découper (106) ladite durée d'opération en n séquences temporelles, la durée d'une séquence étant représentative du fonctionnement dudit système de stockage pour une application donnée ;
   - effectuer (108) pour chacune des n séquences temporelles, des analyses de statistiques d'usage de la batterie quant à l'état de charge SOC et la profondeur de décharge DOD ;
   - déterminer (110) parmi les n séquences temporelles, une pluralité m de séquences qui ont des états de charge et des profondeurs de décharge comparables à des états de charge et des profondeurs de décharge pour la durée d'opération ;
   - déterminer (112) parmi les m séquences comparables, des séquences symétriques correspondant à des séquences ayant un état de charge en fin de période égal à l'état de charge en début de période ; et

- sélectionner (114) parmi les séquences symétriques, une séquence représentative d'un profil de sollicitation pour ledit système de stockage.

**2.** Le procédé selon la revendication 1 comprenant une étape initiale de filtrage des données, consistant à déterminer sur la période de collecte des données, une sous-période de surveillance, correspondant soit à une période avec le moins de trous de données, soit à une période où il y a le moins de données non numériques.

**3.** Le procédé selon la revendication 1 ou 2 dans lequel la durée d'opération correspond à une moyenne des heures d'opération sur la période de surveillance dudit système de stockage.

**4.** Le procédé selon l'une quelconque des revendications 1 à 3 dans lequel l'étape d'analyses de statistiques pour la durée d'opération est faite sur des histogrammes du temps passé par intervalle d'état de charge et sur des histogrammes du temps passé par intervalle de profondeur de décharge.

**5.** Le procédé selon l'une quelconque des revendications 1 à 4 dans lequel l'étape d'analyses de statistiques pour chacune des n séquences temporelles est faite sur des histogrammes, pour chacune des n séquences, du temps passé par intervalle d'état de charge et sur des histogrammes, pour chacune des n séquences, du temps passé par intervalle de profondeur de décharge.

**6.** Le procédé selon l'une quelconque des revendications 1 à 5 comprenant une étape initiale consistant à vérifier la fiabilité des valeurs d'état de charge, et si besoin une étape consistant à calculer un état de charge fiable.

**7.** Le procédé selon l'une quelconque des revendications 1 à 6 comprenant une étape consistant à calculer des valeurs de profondeur de décharge.

**8.** Le procédé selon l'une quelconque des revendications 1 à 7 dans lequel l'étape de sélectionner une séquence représentative d'un profil de sollicitation pour ledit système de stockage, consiste à : - récupérer des profils de courant ou des profils de puissance correspondant aux séquences symétriques ; - calculer une différence point par point entre chaque profil de courant ou de puissance récupéré et un profil moyen ; et - sélectionner un profil correspondant à celui ayant une différence minimale avec le profil moyen.

**9.** Le procédé selon l'une quelconque des revendications 1 à 8 comprenant de plus une étape consistant en une mise à l'échelle du profil de sollicitation sélectionné comme profil représentatif.

**10.** Programme d'ordinateur comportant des instructions de code pour l'exécution des étapes du procédé selon l'une quelconque des revendications 1 à 9, lorsque ledit programme est exécuté par un processeur.

**11.** Un dispositif de détermination de profils de sollicitation pour système de stockage par batterie comprenant des moyens pour mettre en œuvre les étapes du procédé selon l'une quelconque des revendications 1 à 9.

**12.** Le dispositif selon la revendication 11 dans lequel le système de stockage est stationnaire, de préférence un système de stockage par batteries « BESS ».

**13.** Le dispositif selon la revendication 12 dans lequel le système de stockage comporte au moins une batterie au lithium-ion.

**14.** Dispositif pour simuler le vieillissement des batteries d'un système de stockage par batterie, le dispositif comprenant au moins un processeur pour exécuter un modèle de vieillissement de batterie ainsi qu'un deuxième dispositif de détermination de profils de sollicitation selon la revendication 11, ledit modèle étant appliqué sur la base d'un profil de sollicitation déterminé par ledit deuxième dispositif, ledit profil étant donc obtenu par le procédé selon l'une quelconque des revendications 1 à 9.

**Patentansprüche**

**1.** Verfahren zur Bestimmung eines Belastungsprofils für ein Batteriespeichersystem, wobei das Verfahren durch einen Computer ausgeführt wird und mindestens die Schritte beinhaltet, bestehend aus:

- Berechnen (102) einer Betriebsdauer eines Batteriespeichersystems ausgehend von einer Datenhistorie, die über einen Überwachungszeitraum des Systems gesammelt wurden, wobei die Daten mindestens Werte des Stroms I(t), der Temperatur T(t), der Spannung U(t) und Werte des Ladungszustands SOC beinhalten;
- Durchführen (104), für die Betriebsdauer, von statistischen Analysen der Nutzung der Batterie in Bezug auf den Ladungszustand SOC und die Entladungstiefe DOD;

- Zerlegen (106) der Betriebsdauer in n zeitliche Sequenzen, wobei die Dauer einer Sequenz für das Betreiben des Speichersystems für eine gegebene Anwendung repräsentativ ist;

- Durchführen (108) von statistischen Analysen der Nutzung der Batterie in Bezug auf den Ladungszustand SOC und die Entladungstiefe DOD für jede der n zeitlichen Sequenzen;
- Bestimmen (110), unter den n zeitlichen Sequenzen, einer Vielzahl m von Sequenzen, die Ladungszustände und Entladungstiefen aufweisen, die mit Ladungszuständen und Entladungstiefen für die Betriebsdauer vergleichbar sind;
- Bestimmen (112), unter den m vergleichbaren Sequenzen, von symmetrischen Sequenzen, die Sequenzen entsprechen, die einen Ladungszustand am Ende des Zeitraums aufweisen, der gleich einem Ladungszustand am Anfang des Zeitraums ist; und
- Auswählen (114), unter den symmetrischen Sequenzen, einer Sequenz, die für ein Belastungsprofil für das Speichersystem repräsentativ ist.

2. Verfahren nach Anspruch 1, beinhaltend einen anfänglichen Filterschritt der Daten, der aus dem Bestimmen, über den Zeitraum der Datensammlung, eines Überwachungsteilzeitraums besteht, entsprechend entweder einem Zeitraum mit den wenigstens Datenlücken oder einem Zeitraum, in dem es die wenigsten nichtnumerischen Daten gibt.

3. Verfahren nach Anspruch 1 oder 2, wobei die Betriebsdauer einem Durchschnitt der Betriebsstunden über den Überwachungszeitraum des Speichersystems entspricht.

4. Verfahren nach einem der Ansprüche 1 bis 3, wobei der Schritt der statistischen Analyse für den Betriebszeitraum an Histogrammen der verstrichenen Zeit pro Intervall des Ladungszustands und an Histogrammen der verstrichenen Zeit pro Intervall der Entladungstiefe erfolgt.

5. Verfahren nach einem der Ansprüche 1 bis 4, wobei der Schritt der statistischen Analyse für jede der n zeitlichen Sequenzen für jede der n Sequenzen an Histogrammen der verstrichenen Zeit pro Intervall des Ladungszustands und für jede der n Sequenzen an Histogrammen der verstrichenen Zeit pro Intervall der Entladungstiefe erfolgt.

6. Verfahren nach einem der Ansprüche 1 bis 5, beinhaltend einen anfänglichen Schritt, der aus dem Verifizieren der Zuverlässigkeit der Werte des Ladungszustands besteht und gegebenenfalls einen Schritt, der aus dem Berechnen eines Zustands zuverlässigen Ladungszustands besteht.

7. Verfahren nach einem der Ansprüche 1 bis 6, beinhaltend einen Schritt, der aus dem Berechnen von Werten der Entladungstiefe besteht.

8. Verfahren nach einem der Ansprüche 1 bis 7, wobei der Schritt des Auswählens einer Sequenz, die für ein Belastungsprofil für das Speichersystem repräsentativ ist, besteht aus: -Abrufen des Stromprofils oder des Leistungsprofils entsprechend der symmetrischen Sequenzen; -Berechnen einer Differenz zwischen jedem abgerufenen Strom- oder Leistungsprofil und eines durchschnittlichen Profils; und -Auswählen eines Profils, das jenem mit einer minimalen Differenz zu dem durchschnittlichen Profil entspricht.

9. Verfahren nach einem der Ansprüche 1 bis 8, zusätzlich beinhaltend einen Schritt, bestehend aus einer Skalierung des ausgewählten Belastungsprofils als repräsentatives Profil.

10. Computerprogramm, umfassend Codeanweisungen zur Ausführung der Schritte des Verfahrens nach einem der Ansprüche 1 bis 9, wenn das Programm durch einen Prozessor ausgeführt wird.

11. Vorrichtung zur Bestimmung von Belastungsprofilen für das Batteriespeichersystem, beinhaltend Mittel zur Durchführung der Schritte des Verfahrens nach einem der Ansprüche 1 bis 9.

**12.** Vorrichtung nach Anspruch 11, wobei das Speichersystem stationär, vorzugsweise ein Batteriespeichersystem "BESS" ist.

**13.** Vorrichtung nach Anspruch 12, wobei das Speichersystem mindestens eine Lithiumionenbatterie umfasst.

**14.** Vorrichtung zum Simulieren der Alterung von Batteriespeichersystemen, wobei die Vorrichtung mindestens einen Prozessor zum Ausführen eines Batteriealterungsmodells sowie eine zweite Vorrichtung zur Bestimmung von Belastungsprofilen nach Anspruch 11 beinhaltet, wobei das Modell auf die Basis eines Belastungsprofils angewendet wird, die durch die zweite Vorrichtung bestimmt wird, wobei das Profil daher durch das Verfahren nach einem der Ansprüche 1 bis 9 erhalten wird.

## Claims

**1.** Method for determining stress profiles for battery storage system, the method being implemented by computer and comprising at least steps consisting of:

- calculating (102) an operation duration of a battery storage system, from a data history collected over a monitoring period of said system, the data comprising at least current I(t), temperature T(t), voltage U(t) values and state of charge SOC values;
- conducting (104) for the operation duration, battery usage statistics analyses concerning the state of charge SOC and the depth of discharge DOD;

  - dividing (106) said operation duration into n time sequences, the duration of a sequence representative of the operation of said storage system for a given application;

- conducting (108) for each of the n time sequences, battery usage statistics analyses concerning the state of charge SOC and the depth of discharge DOD;
- determining (110) among the n time sequences, a plurality m of sequences that have states of charge and depths of discharge comparable to states of charge and depths of discharge for the operation duration;
- determining (112) among the m comparable sequences, symmetric sequences corresponding to sequences having a state of charge at the end of the period equal to the state of charge at the beginning of the period; and
- selecting (114) among the symmetric sequences, a sequence representative of a stress profile for said storage system.

**2.** Method according to claim 1 comprising an initial step of filtering data, consisting of determining over the data collection period, a monitoring sub-period, corresponding either to a period with the least data gaps, or to a period where there is the least non-numerical data.

**3.** Method according to claim 1 or 2 wherein the operation duration corresponds to an average of the operation hours over the monitoring period of said storage system.

**4.** Method according to any of claims 1 to 3 wherein the step of statistics analysis for the operation duration is done over histograms of the time spent per state of charge interval and over histograms of the time spent per depth discharge interval.

**5.** Method according to any of claims 1 to 4 wherein the step of statistics analysis for each of the n time sequences is done over histograms, for each of the n sequences, of the time passed per state of charge interval and over histograms, for each of the n sequences, of the time passed per depth discharge interval.

**6.** Method according to any of claims 1 to 5 comprising an initial step consisting of verifying the reliability of the state of charge values, and if needed a step consisting of calculating a reliable state of charge.

**7.** Method according to any of claims 1 to 6 comprising a step consisting of calculating depth of discharge values.

**8.** Method according to any of claims 1 to 7 wherein the step of selecting a sequence representative of a stress profile for said storage system, consists of: - retrieving current profiles or power profiles corresponding to the symmetrical sequences; - calculating a point-by-point difference between each current or power profile retrieved and an average profile; and - selecting a profile corresponding to the one having a minimum difference with the average profile.

9. Method according to any of claims 1 to 8 further comprising a step consisting of a scaling of the stress profile selected as representative profile.

10. Computer program comprising code instructions for executing steps of the method according to any of claims 1 to 9, when said program is executed by a processor.

11. Device for determining stress profiles for a battery storage system comprising means for implementing the steps of the method according to any of claims 1 to 9.

12. Device according to claim 11 wherein the storage system is stationary, preferably a battery storage system "BESS".

13. Device according to claim 12 wherein the storage system comprises at least one lithium-ion battery.

14. Device for simulating the aging of the batteries of a battery storage system, the device comprising at least one processor for executing a battery aging model as well as a second device for determining stress profiles according to claim 11, said model being applied based on a stress profile determined by said second device, said profile therefore being obtained by the method according to any of claims 1 to 9.

101

Données BESS : U(t),
I(t), T(t), SOC(t)

100

Calcul d'une durée d'opération sur la totalité de la période
de collecte des données

102

Analyse de statistiques d'usage de la batterie (SOC, DOD)
sur la totalité de la période

104

Découpage de la période en n séquences d'une durée
représentative

106

Analyse de statistiques d'usage de la batterie(SOC, DOD)
pour les n séquences

108

Détermination de m séquences les plus proches

110

Détermination de p séquences symétriques parmi les m
séquences

112

Sélection d'un profil de sollicitation type

114

Fig. 1

Fig. 2a

Fig. 2b

Fig. 3a

Fig. 3b

400

101

Données BESS : U, I,
T, SOC

Fiabilisation des données initiales BESS — 402

(102) — 404

Vérification fiabilité du SOC ;
Calcul d'un indicateur de SOC fiable — 406

(104, 106, 108, 110, 112, 114) — 408

Mise à l'échelle et prise en compte des spécifications /
limites batteries — 410

Profil de sollicitation type à l'échelle — 412

Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 106980725 B
- FR 3118310 A1
- US 2022037609 A1
- EP 3936878 A1

**Littérature non-brevet citée dans la description**

- **S. B. VILSEN ; D.-I. STROE**. Transfer Learning for Adapting Battery State-of-Health Estimation From Laboratory to Field Operation. *IEEE Access*, 2022, vol. 10, 26514-26528

- **D'A. BHATT ; W. ONGSAKUL ; N. MADHU MANJIPARAMBIL ; J. G. SINGH**. Machine learning-based approach for useful capacity prediction of second-life batteries employing appropriate input selection. *International Journal of Energy Research*, 2021, vol. 45 (15), 21023-21049